Europäisches Patentamt

European Patent Office

Office européen des brevets

(11) Publication number: **0 414 372 A2**

# EUROPEAN PATENT APPLICATION

(21) Application number: 90307877.2

(51) Int. Cl.5: **H01L 21/306**, H01L 21/308

(22) Date of filing: 19.07.90

(30) Priority: 21.07.89 JP 189172/89
28.09.89 JP 253441/89

(43) Date of publication of application:
27.02.91 Bulletin 91/09

(84) Designated Contracting States:
DE FR GB

(71) Applicant: SONY CORPORATION
7-35 Kitashinagawa 6-Chome Shinagawa-ku
Tokyo 141(JP)

(72) Inventor: Kadomura, Shingo
c/o Patents Div., Sony Corp., 6-7-35
Kitashinagawa
Shinagawa-ku, Tokyo 141(JP)

(74) Representative: Thomas, Christopher Hugo et
al
D Young & Co 10 Staple Inn
London WC1V 7RD(GB)

(54) Dry etching methods.

(57) A dry etching process utilizes a gas for forming a side wall protective layer (15) when etching a trench (14) in monocrystalline silicon, the gas comprising a base etching gas to which is added at least chlorine trifluoride, or in the alternative silicon and fluorine.

**FIG.2 (B)**

# DRY ETCHING METHODS

This invention relates to dry etching methods applicable to anisotrophic etching in semiconductor manufacture, and to composite gases for such methods.

Silicon trench etching is important in ultra-large LSI (ULSI) manufacture of high mega-bit DRAMs and high speed bipolar devices. For performing the etching process, various etching gases have been developed and used. Typically, fluorine (F) type gas, chlorine (Cl) type gas, or a mixture thereof are used. For example, Japanese patent (unexamined) publication (Tokkai) 63/73526 discloses an etching method utilizing $SiCl_4/N_2$ type gas.

In a dry etching method for monocrystalline silicon, an $SiO_2$ mask is formed on the inner periphery perpendicular to the plane of a monocrystal substrate, and then etching is performed with $SiCl_4/N_2$ type etching gas. In this proces, $Si_xN_y$ formed as a reaction product during the etching process is used as a protective layer when forming a trench.

However, there are problems with such methods.

Firstly, the reaction product forming the protective layer, can obstruct etching and lower the etching speed or efficiency. Secondly, in a batch type etcher, the etching rate or efficiency can be lowered due to a loading effect. To solve such problems of low efficiency, it has been proposed in "1988 Shuuki Obutsu" 7a-K-7 to use $SF_6/SiCl_4/N_2$ type etching gas, but this can cause contamination.

On the other hand, when the required pattern cannot be formed by a lithographic process and has to be patterned by a self-alignment process, the self-alignment process is performed by forming side walls of $SiO_2$ with tetraethoxysilane, and then etching using the side walls as a mask. However, tapers on the side walls may cause scattering of an injected ion beam, so causing scoop or under-cut immediately beneath the mask.

According to the present invention there is provided a composite gas for dry etching to form a desired configuration of trench in monocrystalline silicon, the gas being composed of:
a base composite gas for etching the monocrystalline silicon; and an additive gas added to said base composite gas and containing at least $ClF_3$ for forming a protective layer on the side wall of said trench.

According to the present invention there is also provided a composite gas for dry etching to forming a desired configuration of trench in monocrystalline silicon, the gas being composed of:
a base composite gas for etching the monocrystalline silicon; and an additive gas added to said base composite gas, and containing at least Si and F as components.

According to the present invention there is also provided a dry etching process for forming a trench in monocrystalline silicon, the process comprising the steps of:
forming an opening in an $SiO_2$ layer formed on a monocrystalline silicon substrate;
performing etching utilizing the residual $SiO_2$ layer as a masking layer and with an etching gas, which is composed of:
a base composite gas for etching the monocrystalline silicon; and an additive gas added to said base composite gas, said additive gas containing at least $ClF_3$ for forming a protective layer on the side wall of said trench.

According to the present invention there is also provided a dry etching process for forming a trench in monocrystalline silicon, the process comprising the steps of:
forming an opening in an $SiO_2$ layer formed on a monocrystalline silicon substrate;
performing etching utilizing the residual $SiO_2$ layer as a masking layer and with an etching gas, which is composed of:
a base composite gas for etching the monocrystalline silicon; and an additive gas added to said base composite gas, said additive gas being containing at least Si and F as components.

The invention will now be described by way of example with reference to the accompaning drawings, throughout which like parts are referred to by like references, and in which:
Figures 1(A), 1(B) and 1(C) are sections showing stages in a dry etching process according to the invention; and
Figures 2(A) and 2(B) are sections showing stages in another dry etching process according to the invention.

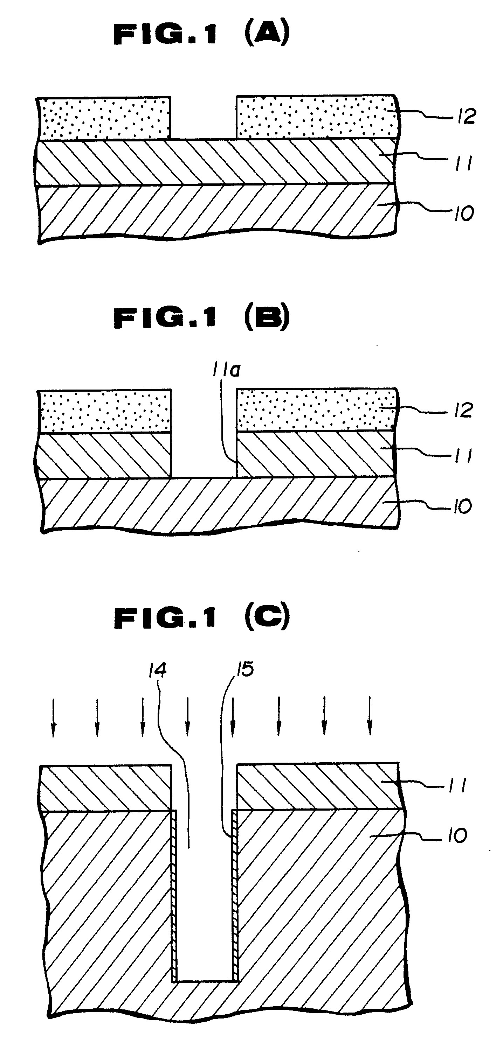

Referring to Figures 1(A), 1(B) and 1(C), a preferred etching process will be discussed in terms of etching a monocrystalline silicon substrate. An $SiO_2$ layer 11 is formed on a monocrystalline silicon substrate 10. On the $SiO_2$ layer 11, a resist layer 12 is formed and defines an opening where a trench 14 is to be formed, as shown in Figure 1(A). The opening in the resist layer 12 is formed by a known patterning process.

Then, utilizing the resist layer 12 as a mask, reactive ion beam etching (RIE) is used to form an opening 11a through the $SiO_2$ layer 11, as shown in Figure 1(B). After forming the opening 11a, the resist layer 12 is removed. Then, the trench 14 of a desired depth is formed by a bias charge type ECR etching device, as shown in Figure 1(C). During this etching process, the SiO₂ layer 11 serves as a mask.

The etching process for forming the trench 14 is performed in the following conditions. The pressure is set at 10 mTorr (0.013 Pascal). RF bias is applied at 300W. $SiCl_4/N_2$ type gas is used for forming a side wall protective layer 15. In order to improve the etching rate, 10% of $ClF_3$ is added.

It has been found that radical fluorine (F*) and radical chlorine (Cl*) generated by dissociation of $ClF_3$ serve to improve the etching rate. Therefore, the presence of $ClF_3$ in the gas for forming the protective layer 15 may compensate lowering of the etching rate due to loading effect. As a result, even when the area on which etching is performed in so wide as possibly to cause loading effect, the etching rate can be maintained at satisfactorily high level.

It will be appreciated that the bonding energy of $ClF_3$ is Cl-F = 61.4 Kcal/mol, which is smaller than $SF_6$ (SF = 90 Kcal/mol), $NF_3$ (N-F = 63 Kcal/mol) and $CF_4$ (C-F = 107 Kcal/mol). As can be seen herefrom, since $ClF_3$ has a smaller bonding energy than other gases, Cl* and F* can be obtained more easily therefrom.

It should be appreciated that although the gas used in the preferred process is specified to be $SiCl_4/N_2$ type gas to which $ClF_3$ is added, any appropriate gas, such as $Cl_2/N_2$ type, $Cl_2/O_2$ type, $Br_2/N_2$ type, $HBr/N_2$ type or $SiCl_4/O_2$ type gases, can be used as replacements for the specific gas. Therefore, the type of the gas to which $ClF_3$ is added, is to be considered not essential to the subject matter of the invention. Furthermore, although the content of $ClF_3$ is specified as 10%, the content is variable in a range of 1% to 90%. In addition, as the gas for performing etching while forming a protective layer on the side wall, a gas composed of chlorine, bromine and compounds thereof can also be used. As above, can be added to the gas in the $ClF_3$ content of 1% to 90%. Furthermore, it is possible to add a rare gas.

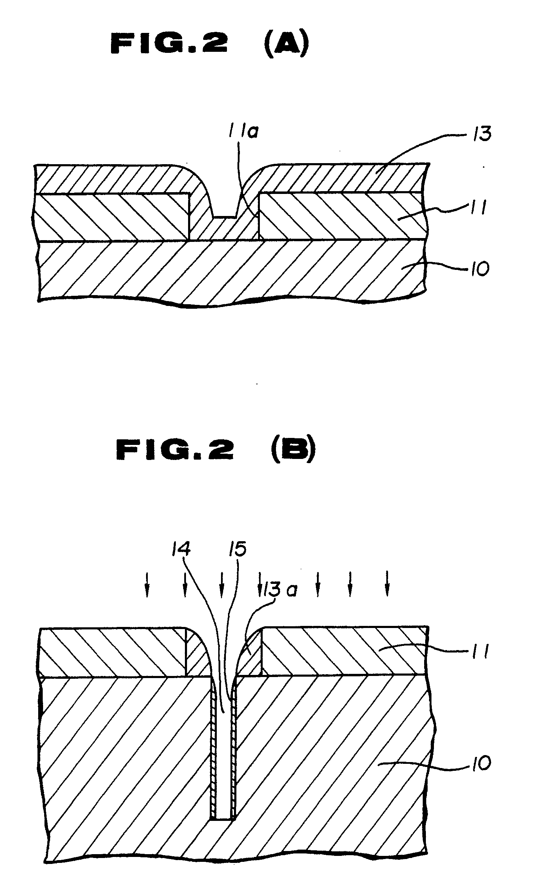

Figures 2(A) and 2(B) show another preferred process for implementing the present invention. In Figure 2(A), the silicon substrate 11 is formed with an SiO₂ layer 11 of thickness 1.0µm. An opening 11a having a greater diameter than the desired diameter of a trench 14 is formed through the SiO₂ layer 11. In this example, the diameter of the opening 11a is 1.0µm. For this substrate, chemical vapour deposition (CVD) is performed utilizing TEOS gas as the source gas for forming an SiO₂ layer 13 of thickness 400 nm. Then, etch-back treatment is performed for forming a side wall 13a on the side wall of the opening 11a. The internal diameter of the side wall 13a is 0.3µm. The side wall 13a has 60° to 70° of taper due to the influence of the etch-back.

Thereafter, utilizing the TEOS layer and the SiO₂ layer 11 as a mask, etching is performed by mean of bias charge type ECR etching apparatus for forming a desired depth of the trench 14, as shown in Figure 2(B). In this etching process, a side wall protective layer 15 is formed.

The following are the conditions for performing etching for forming the trench. As an etching gas, a mixture gas of $SiCl_4$, $N_2$ and $SiF_4$ is used. These gases are supplied at a flow rate ratio of $SiCl_4/N_2/SiF_4$ = 10 SCCM/10 SCCM/10 SCCM. The pressure is set at 10 mTorr (0.013 Pascal), the microwave power is set as 850W, and Vdc is set at -250V. During this etching process, F* is generated from the $SiF_4$ to prevent lowering of the etching rate. Furthermore, the Si in the $SiF_4$ may serve to protect the side wall, so avoiding scoop and undercut. Therefore, with this process, the desired configuration of the trench can be formed.

The specific gas $SiF_4$, that is an Si and F containing gas, can be added not only for the specified combined gas but also for other combinations of gases, such as $Br_2/N_2$. In the later case, the $SiF_4$ is added in the flow rate ratio of $Br_2/N_2/SiF_4$ = 10 SCCM/10 SCCM/10 SCCM. When etching is performed with the conditions set forth above, an equivalent result can be obtained.

## Claims

1. A composite gas for dry etching to form a desired configuration of trench (14) in monocrystalline silicon, the gas being composed of:
a base composite gas for etching the monocrystalline silicon; and an additive gas added to said base composite gas and containing at least $ClF_3$ for forming a protective layer (15) on the side wall of said trench (14).

2. A composite gas according to claim 1 wherein said base composite gas is $SiCl_4/N_2$ type gas, $Cl_2/N_2$ type gas, $Cl_2/O_2$ type gas, $Br_2/N_2$ type gas, $HBr/N_2$ type gas or $SiCl_4/O_2$ type gas.

3. A composite gas according to claim 1 or claim 2 wherein said additive gas is added to the base composite gas in a range of 1 to 90%.

4. A composite gas for dry etching to forming a desired configuration of trench (14) in monocrystalline silicon, the gas being composed of:
a base composite gas for etching the monocrystalline silicon; and an additive gas added to said base composite gas, and containing at least Si and F as components.

5. A composite gas according to claim in wherein said base composite gas is $SiCl_4/N_2$ type gas or $Br_2/N_2$ type gas.

6. A composite gas according to claim in or claim 5 wherein said additive gas is $SiF_4$ gas.

7. A dry etching process for forming a trench (14) in monocrystalline silicon, the process comprising the steps of:

forming an opening (11a) in an $SiO_2$ layer (11) formed on a monocrystalline silicon substrate (10);

performing etching utilizing the residual $SiO_2$ layer (11) as a masking layer and with an etching gas, which is composed of:

a base composite gas for etching the monocrystalline silicon; and an additive gas added to said base composite gas, said additive gas containing at least $ClF_3$ for forming a protective layer (15) on the side wall of said trench (14).

8. A process according to claim 7 wherein said base composite gas is $SiCl_4/N_2$ type gas, $Cl_2/N_2$ type gas, $Cl_2/O_2$ type gas, $Br_2/N_2$ type gas, $HBr/N_2$ type gas or $SiCl_4/O_2$ type gas.

9. A process according to claim 7 wherein said additive gas is added to the base composite gas in a range of 1 to 90%.

10. A dry etching process for forming a trench (14) in monocrystalline silicon, the process comprising the steps of:

forming an opening (11a) in an $SiO_2$ layer (11) formed on a monocrystalline silicon substrate (10);

performing etching utilizing the residual $SiO_2$ layer (11) as a masking layer and with an etching gas, which is composed of:

a base composite gas for etching the monocrystalline silicon; and an additive gas added to said base composite gas, said additive gas being containing at least Si and F as components.

11. A process according to claim 10 wherein said base composite gas is $SiCl_4/N_2$ type gas or $Br_2/N_2$ type gas.

12. A process according to claim 10 wherein said additive gas is $SiF_4$ gas.

# FIG.1 (A)

# FIG.1 (B)

# FIG.1 (C)

# FIG.2 (A)

# FIG.2 (B)